(19)

Europäisches
Patentamt
European
Patent Office
Office européen
des brevets

(11) **EP 2 960 052 A1**

(12) **EUROPEAN PATENT APPLICATION**
published in accordance with Art. 153(4) EPC

(43) Date of publication:
**30.12.2015 Bulletin 2015/53**

(21) Application number: **14753841.7**

(22) Date of filing: **14.02.2014**

(51) Int Cl.:
**B32B 9/00** *(2006.01)*    **C23C 14/08** *(2006.01)*

(86) International application number:
**PCT/JP2014/053409**

(87) International publication number:
**WO 2014/129387 (28.08.2014 Gazette 2014/35)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **20.02.2013 JP 2013031224**

(71) Applicant: **Toyobo Co., Ltd.**
**Osaka-shi**
**Osaka 530-8230 (JP)**

(72) Inventors:
• **MURAKAMI, Sachi**
**Otsu-shi**
**Shiga 520-0292 (JP)**
• **INAGAKI, Kyoko**
**Otsu-shi**
**Shiga 520-0292 (JP)**
• **ISEKI, Kiyoshi**
**Otsu-shi**
**Shiga 520-0292 (JP)**

(74) Representative: **Vossius & Partner**
**Patentanwälte Rechtsanwälte mbB**
**Siebertstrasse 3**
**81675 München (DE)**

(54) **GAS BARRIER FILM**

(57)    The present invention has been made in view of the above-mentioned conventional technical problems. That is, an object of the present invention is to provide a gas barrier film excellent in barrier properties to oxygen and water vapor, preferably excellent in water vapor barrier properties after being left to stand in a humidified environment for a prescribed period.

EP 2 960 052 A1

**Description**

TECHNICAL FIELD

The present invention relates to a gas barrier film used for packaging materials for foodstuffs, pharmaceutical products, electronic parts, etc. as well as electronic appliances such as solar cells, electronic paper, and film liquid crystals which are required to have water vapor barrier properties.

BACKGROUND ART

Packaging materials used for foodstuffs, pharmaceutical products, etc. are required to have characteristics of blocking gases such as oxygen in the air and water vapor which accelerate denaturation such as oxidation, that is, gas barrier properties, to enable long time storage of the contents of the packaging materials. Particularly, gas barrier materials used for solar cells, electronic devices such as organic EL devices, electronic parts, etc. are required to have higher gas barrier properties than packaging materials for foodstuffs, pharmaceutical products, etc.

Conventionally, those which have been used as packaging materials are films obtained by layering polymer resin compositions of polyvinyl alcohol (PVA), ethylene-vinyl alcohol copolymer (EVOH), polyvinylidene chloride resin (PVDC), or polyacrylonitrile (PAN), which are generally said to have relatively high gas barrier properties.

However, gas barrier layered films made of the above-mentioned PVA-based or EVOH-based polymer resin compositions exhibit lowering of gas barrier properties under high temperature or high humidity since they have high temperature dependency and humidity dependency. Further, PVDC and PAN have a problem that the risk of generating harmful substances is high at the time of disposal and incineration of them.

Conventionally, as packaging materials required to have higher gas barrier properties, those obtained by depositing a metal such as aluminum on a plastic film by vapor deposition have been used. However, in the case where such a packaging material is used, since the metal thin film is opaque, there are problems that the contents cannot be distinguished and that content inspection by a metal detector or a heating treatment by a microwave oven is impossible.

Accordingly, to solve the problems, it is proposed to exhibit high gas barrier properties by a film obtained by forming an aluminum oxide thin film on a plastic film (for example, refer to Patent Document 1).

Further, there is a report of a gas barrier film containing an aluminum oxide/nitride and/or a silicon oxide/nitride as an inorganic oxide thin film formed on a plastic film in order to improve the gas barrier properties (for example, refer to Patent Document 2).

Still further, there is also a report of a thin film obtained by mixing and heating magnesium oxide and aluminum oxide particles as an inorganic oxide thin film formed on a plastic film (for example, refer to Patent Documents 3 to 5).

However, although having high barrier properties to oxygen and water vapor, the above-mentioned conventional gas barrier films are insufficient in the water vapor barrier properties after being left to stand in a humidified environment for a prescribed period, and are incapable of exhibiting sufficient water vapor barrier properties depending on the contents.

PRIOR ART DOCUMENTS

PATENT DOCUMENTS

> Patent Document 1: JP-A-2004-82400
> Patent Document 2: JP-A-2002-361778
> Patent Document 3: JP-A-sho-61-193841
> Patent Document 4: JP-A-hei-07-126835
> Patent Document 5: JP-A-2012-158820

SUMMARY OF THE INVENTION

PROBLEMS TO BE SOLVED BY THE INVENTION

The present invention has been made in view of the above-mentioned conventional technical problems. That is, an object of the present invention is to provide a gas barrier film excellent in barrier properties to oxygen and water vapor, preferably excellent in water vapor barrier properties after being left to stand in a humidified environment for a prescribed period.

SOLUTIONS TO THE PROBLEMS

Inventors of the present invention made earnest investigations and consequently found that the above-mentioned problems can be solved by the following means, and completed the present invention.

That is, the present invention is configured as follows.

(1) A gas barrier film comprising an inorganic compound thin film formed on at least one surface of a plastic film, wherein the inorganic compound thin film contains aluminum oxide and magnesium oxide as main components, the ratio of magnesium oxide is not less than 5 mass% and not more than 90 mass% relative to 100 mass% in total of aluminum oxide and magnesium oxide contained in the inorganic compound thin film, and the thickness of the inorganic compound thin film is 5 to 80 nm.

(2) The gas barrier film comprising an inorganic compound thin film formed on at least one surface of a plastic film according to above (1), wherein the gas barrier film has a rate of change of water vapor transmission rate ($\Delta$WVTR) of not more than 50% after being treated at 40°C and 90% RH for 50 hours.

(3) The gas barrier film according to above (1) or (2), wherein the ratio of magnesium oxide is not less than 5 mass% and not more than 25 mass% relative to 100 mass% in total of aluminum oxide and magnesium oxide contained in the inorganic compound thin film, and the gas barrier film has a rate of change of water vapor transmission rate ($\Delta$WVTR) of not more than 50% after being treated at 40°C and 90% RH for 50 hours.

(4) The gas barrier film according to above (1) or (2), wherein the ratio of magnesium oxide is not less than 70 mass% and not more than 90 mass% relative to 100 mass% in total of aluminum oxide and magnesium oxide contained in the inorganic compound thin film, and the gas barrier film has a rate of change of water vapor transmission rate ($\Delta$WVTR) of not more than 50% after being treated at 40°C and 90% RH for 50 hours.

(5) The gas barrier film according to any one of above (1) to (4), wherein the thickness of the plastic film is not more than 50 $\mu$m.

(6) The gas barrier film according to any one of above (1) to (5), wherein the inorganic compound thin film is obtained by separately heating aluminum oxide and magnesium oxide.

EFFECTS OF THE INVENTION

According to the present invention, it is made possible to provide a transparent gas barrier film excellent in barrier properties to oxygen and water vapor and having particularly high water vapor barrier properties. The gas barrier film is preferably usable for packaging uses for various kinds of foodstuffs, pharmaceutical products, and industrial products and industrial uses for solar cells, electronic paper, organic EL devices, semiconductor devices, etc., is relatively inexpensive in production cost, and has high practicality.

MODE FOR CARRYING OUT THE INVENTION

A gas barrier film of the present invention is a film including an inorganic compound thin film formed on at least one surface of a plastic film. Hereinafter, the present invention will be described in detail.

[Substrate film]

A plastic film used in the present invention is made of an organic polymer resin. Examples of the organic polymer resin include polyamides typified by nylon 4,6, nylon 6, nylon 6,6, nylon 12, etc.; polyesters typified by polyethylene terephthalate, polybutylene terephthalate, polyethylene-2,6-naphthalate, etc.; polyolefins typified by polyethylene, polypropylene, polybutene, etc.; as well as polyvinyl chloride, polyvinylidene chloride, polyvinyl alcohol, wholly aromatic polyamides, polyamide imides, polyimides, polyether imides, polysulfones, polystyrene, polylactic acid, tetrafluoroethylene, monochlorotrifluoroethylene, etc. Among them, polyamides and polyesters are preferable, and polyesters are particularly preferable in terms of heat resistance, dimensional stability, and transparency. One or more kinds of the organic polymer resins may be used.

Specific examples of preferable polyamides include polycaproamide (nylon 6), poly-$\varepsilon$-aminoheptanoic acid (nylon 7), poly-$\varepsilon$-aminononanoic acid (nylon 9), polyundecaneamide (nylon 11), polylaurinlactam (nylon 12), polyethylenediamine adipamide (nylon 2,6), polytetramethylene adipamide (nylon 4,6), polyhexamethylene adipamide (nylon 6,6), polyhexamethylene sebacamide (nylon 6,10), polyhexamethylene dodecamide (nylon 6,12), polyoctamethylene dodecamide (nylon 8,12), polyoctamethylene adipamide (nylon 8,6), polydecamethylene adipamide (nylon 10,6), polydecamethylene sebacamide (nylon 10,10), polydodecamethylene dodecamide (nylon 12,12), metaxylenediamine-6 nylon (MXD6), etc. The above-mentioned polyamides may be copolymers containing these compounds as a main component, and examples thereof include caprolactam/laurinlactam copolymers, caprolactam/hexamethylenediammonium adipate copolymers, laurinlactam/hexamethylenediammonium adipate copolymers, hexamethylenediammonium adipate/hexamethylenediammonium sebacate copolymers, ethylenediammonium adipate/hexamethylenediammonium adipate copolymers, caprolactam/hexamethylenediammonium adipate/hexamethylenediammonium sebacate copolymers, etc. It is effective to add, as a flexibility modifying component for films, plasticizers such as aromatic sulfonamides, p-hydroxybenzoic acid, and esters, elastomer components with low elastic modulus, lactams, etc. to the polyamides.

Specific examples of preferable polyesters include polyethylene terephthalate, polybutylene terephthalate, polyethylene-2,6-naphthalate and also copolymers containing these polyesters as a main component. A dicarboxylic acid component composing the polyester copolymers preferably contains as a main component an aromatic dicarboxylic acid such as terephthalic acid, isophthalic acid, phthalic acid, or 2,6-naphthalenedicarboxylic acid, a polyfunctional carboxylic acid such as trimellitic acid or pyromellitic acid, or an aliphatic dicarboxylic acid such as adipic acid or sebacic acid. Further, a glycol component composing the polyester copolymers preferably contains as a main component an aliphatic glycol such as ethylene glycol, 1,4-butanediol as well as diethylene glycol, propylene glycol, or neopentyl glycol, an aromatic glycol such as p-xylylene glycol, an alicyclic glycol such as 1,4-cyclohexanedimethanol, or polyethylene glycol having an average molecular weight of 150 to 20000. The polyester copolymers may be copolymers obtained by further copolymerizing other components.

Publicly known additives may be added to the organic polymer resin composing the plastic film to the extent that the effects of the present invention are not adversely affected. Examples of the additives include lubricants such as silica, ultraviolet absorbers, antistatic agents, plasticizers, coloring agents, etc. The organic polymer resin composing the plastic film may be copolymerized or blended with other polymerizable components other than the above-mentioned organic polymer resin.

A method for producing the plastic film is not particularly limited, and the plastic film is produced by, for example, producing a film by a known method such as a melt extrusion method or a casting method, thereafter stretching the film in the longitudinal direction and/or width direction as necessary, and subjecting the resulting film to cooling and heat fixation.

In the present invention, the plastic film may be a layered film obtained by laminating different or same kind of organic polymer resins. Types of the layers, the number of the layers, the method of layering, etc. are not particularly limited, and the method may be selected arbitrarily among publicly known methods in accordance with the purpose.

In the present invention, the plastic film may be subjected to a surface treatment such as a corona discharge treatment, a glow discharge treatment, a flame treatment, or a surface roughening treatment before an inorganic compound thin film layer as described below is layered, or subjected a publicly known anchor coating treatment, printing, or decoration as long as the effects of the present invention are not adversely affected.

In the present invention, the plastic film preferably has a thickness in the range of not less than 1 $\mu$m and not more than 300 $\mu$m, more preferably has a thickness in the range of not less than 5 $\mu$m and not more than 100 $\mu$m, and most preferably has a thickness in the range of not less than 9 $\mu$m and not more than 50 $\mu$m.

In the present invention, the transparency of the plastic film is not particularly limited. However, in the case of using the obtained gas barrier film for a packaging material which is required to be transparent, the plastic film desirably has a transmittance of not less than 50%.

[Inorganic compound thin film]

An inorganic compound thin film in the present invention contains aluminum oxide and magnesium oxide. Formation of an inorganic compound thin film containing aluminum oxide and magnesium oxide as described above makes it possible to remarkably improve gas barrier properties, particularly barrier properties to vapor water of the film to be obtained.

In the gas barrier film of the present invention, the mass ratio of magnesium oxide contained in the inorganic compound thin film is not particularly limited, but the ratio of magnesium oxide is preferably not less than 5 mass% and not more than 90 mass% relative to 100 mass% in total of aluminum oxide and magnesium oxide contained in the inorganic compound thin film. If the ratio of magnesium oxide is less than 5 mass%, the flexibility tends to be lowered, so that cracking may occur easily at the time of handling and it may become difficult to obtain stable barrier properties. On the other hand, if the ratio of magnesium oxide exceeds 90 mass%, barrier properties are lowered.

Further, since the gas barrier film is sometimes exposed to highly humid environments, it is desirable that deterioration of the gas barrier properties is slight even under high humidity. If the ratio of magnesium oxide is not less than 5 mass% and not more than 25 mass% relative to 100 mass% in total of aluminum oxide and magnesium oxide contained in the inorganic compound thin film, deterioration of the gas barrier properties compared to those before the treatment is slight after the gas barrier film is treated at 40°C and 90% RH for 50 hours. The ratio of magnesium oxide is more preferably not less than 15 mass% and not more than 25 mass%.

If the ratio of magnesium oxide is not less than 5 mass% and not more than 25 mass%, a complex oxide of aluminum oxide and magnesium oxide is easily formed, so that magnesium oxide, which easily reacts with water, hardly exists in form of a simple substance and accordingly is hardly denatured with water.

On the other hand, if the ratio of magnesium oxide is not less than 70 mass% and not more than 90 mass% relative to 100 mass% in total of aluminum oxide and magnesium oxide contained in the inorganic compound thin film, deterioration of the gas barrier properties compared to those before the treatment is slight after the gas barrier film is treated at 40°C and 90% RH for 50 hours.

If the ratio of magnesium oxide is not less than 70 mass% and not more than 90 mass%, aluminum oxide is distributed in a manner of covering the surrounding of magnesium oxide, so that denaturation caused by water can be suppressed.

The ratio of magnesium oxide is more preferably not less than 80 mass% and not more than 90 mass%.

The inorganic compound thin film in the present invention is a thin film containing aluminum oxide and magnesium oxide, and may contain different compounds other than aluminum oxide and magnesium oxide to the extent that the object of the present invention is not hindered. The different compounds may be, for example, various kinds of oxides, nitrides, and mixtures thereof. More specifically, oxides such as silicon oxide, calcium oxide, strontium oxide, scandium oxide, yttrium oxide, lanthanum oxide, cerium oxide, titanium dioxide, zirconium oxide, hafnium oxide, vanadium sesquioxide, and tantalum oxide, nitrides such as magnesium nitride, calcium nitride, lanthanum nitride, titanium nitride, and hafnium nitride, and mixtures thereof can be mentioned. In the case where any different compound is contained, the content thereof is desirably not more than 5 mass% relative to the weight of all the substances in the inorganic compound thin film.

The thickness of the inorganic compound thin film is not particularly limited, but preferably 5 to 80 nm, more preferably not less than 5 nm and not more than 60 nm, and particularly preferably not less than 5 nm and not more than 50 nm.

If the thickness of the inorganic compound thin film is less than 5 nm, satisfactory gas barrier properties are sometimes difficult to be obtained. On the other hand, even if the thickness is excessively increased beyond 80 nm, no effect of improving the gas barrier properties can be obtained correspondingly, and rather cracking of the inorganic thin film by bending becomes significant and the gas barrier properties are already deteriorated after the step of winding the film on a roll immediately after vapor deposition. Further, the vapor deposition speed is increased, so that water vapor barrier properties under high humidity are difficult to be obtained when the thickness is more than 80nm because the vapor deposition speed becomes fast.

In the case where the film is used particularly as a packaging material, the thickness of the plastic film used as a substrate is suitably within the range of not less than 9 $\mu$m and not more than 50 $\mu$m in terms of handleability. If the thickness is not less than 100 $\mu$m, cracking of the inorganic thin film by bending at the time of handling becomes significant, and no barrier improvement effect can be obtained.

The composition and thickness of the inorganic compound thin film mentioned in this application mean the values measured by a calibration curve method using fluorescent X-rays.

The calibration curve employed in this application was produced by the following procedure. A film having an inorganic compound thin film made of aluminum oxide and magnesium oxide was produced, and respective deposition amounts of aluminum oxide and magnesium oxide were measured by inductively coupled plasma emission spectroscopic analysis method (ICP method). The composition of the produced inorganic oxide thin film was calculated based on the measured deposition amounts of aluminum oxide and magnesium oxide.

The thickness was calculated by assuming that the density of the inorganic oxide thin film is 80% of bulk density and that the volumes of aluminum oxide and magnesium oxide were maintained even if they existed in a mixed state. The content wa (%) of aluminum oxide in the film and the content wm (%) of magnesium oxide in the film are calculated according to the following equations (1) and (2) where Ma (g/cm$^2$) is the deposition amount of aluminum oxide per unit area and Mm (g/cm$^2$) is the deposition amount of magnesium oxide per unit area.

$$\text{wa} = 100 \times [\text{Ma}/(\text{Ma} + \text{Mm})] \qquad \ldots \qquad \text{Equation (1)}$$

$$\text{wm} = 100 \cdot \text{wa} \qquad \ldots \qquad \text{Equation (2)}$$

The thickness t (nm) is calculated according to the following equation (3) where Ma (g/cm$^2$) is the deposition amount of aluminum oxide per unit area, $\rho$a (3.97 g/cm$^3$) is the bulk density of aluminum oxide, Mm (g/cm$^2$) is the deposition amount of magnesium oxide per unit area, and $\rho$m (3.65 g/cm$^3$) is the bulk density of magnesium oxide.

$$t = ((Ma/(\rho a \times 0.8) + Mm/(\rho m \times 0.8)) \times 10^{-7} \quad ... \quad \text{Equation (3)}$$

Several types of inorganic oxide thin films with specified thicknesses and compositions were produced, and the calibration curve was produced by measurement with a fluorescent X-ray apparatus.

The values of the thickness measured by the fluorescent X-ray analysis were close to the thickness actually measured by TEM.

Hereinafter, a method for forming an inorganic compound thin film on at least one surface of a plastic film will be described.

The method for forming an inorganic compound thin film is preferably a dry process of forming an inorganic compound thin film on a plastic film as a substrate in a vacuum chamber. More specifically, a publicly known vapor deposition method, for example, a physical vapor deposition method (PVD method) such as a vacuum vapor deposition method, a sputtering method, or an ion plating method, or a chemical vapor deposition method (CVD method) can be employed appropriately. Particularly, in the case of producing a gas barrier film of the present invention used for a packaging material, a vacuum vapor deposition method is preferable in terms of productivity.

In the case where an inorganic compound thin film is formed by a vacuum vapor deposition method, there are methods of resistance heating, high frequency induction heating, electron beam heating, etc. as a method for heating a vapor deposition material.

In the case of producing a gas barrier film of the present invention used for a packaging material, an electron beam heating vapor deposition method is preferable since high speed film formation is possible.

To form an inorganic compound thin film containing aluminum oxide and magnesium oxide by employing an electron beam heating method, aluminum oxide and magnesium oxide are preferably used as vapor deposition materials.

As a preferable method, a method for forming an inorganic compound thin film by separately placing fired particles of aluminum oxide having a purity of not less than 99.9% and fired particles of magnesium oxide having a purity of not less than 99.9%, separately heating the particles for evaporation, and mixing the vapors in vapor phase is preferable.

In the case where a material obtained by mixing aluminum oxide and magnesium oxide is used, since the vapor pressures of aluminum oxide and magnesium oxide are different, magnesium oxide, which has higher vapor pressure, is selectively evaporated if the evaporation is carried out for a long time to change the composition of the mixed material, and the composition of the inorganic compound thin film to be formed is changed accordingly.

A method for separately heating aluminum oxide and magnesium oxide may be a method using two beam sources, and also a method using one beam source to scan the respective materials with the beam in a time-sharing manner and separately heat the materials. Separate heating of the materials enables heating suitable for each of the respective materials, so that splash caused by heating a mixture of materials with different evaporation characteristics can be suppressed, and the composition ratio and thickness can be controlled highly accurately. Further, since a dense thin film tends to be formed easily, the water vapor barrier properties under high humidity can be improved easily.

As the shape of the materials of aluminum oxide and magnesium oxide, granular materials are preferably used. The particle sizes of aluminum oxide particles and magnesium oxide particles are preferably in the range of 2 to 6 mm and 2 to 6 mm, respectively, and the particle size of aluminum oxide particles is more preferably in the range of 3 to 6 mm.

In the case of a powder, the powder is scattered at the time of vacuuming and start of the heating, and in the case of large blocks, the blocks are crushed by heat shock and vapor deposition cannot be carried out well.

In the case of film formation by a vacuum vapor deposition method, the pressure during the vapor deposition is preferably not more than $3.0 \times 10^{-1}$ Pa. If the pressure is higher than $3.0 \times 10^{-1}$ Pa, the energy of vapor-deposited particles is lowered, so that a coarse film tends to be formed and the barrier properties may possibly be lowered.

At the time of film formation by a vacuum vapor deposition method, the temperature of the plastic film is not particularly limited, but it is preferably in the range of -20 to 40°C.

As described above, a gas barrier film of the present invention excellent in barrier properties to oxygen and water vapor, and particularly excellent in water vapor barrier properties can be obtained.

EXAMPLES

Hereinafter, the present invention will be described concretely with reference to examples, but the present invention is not limited to the following examples.

The properties of films obtained in the examples were measured and evaluated by the following methods.

1) Oxygen transmission rate

According to JIS K7126-2 A, measurement was carried out under the conditions of 23°C and 65% RH using an Oxygen transmission rate measurement apparatus (OX-TRAN 2/21, manufactured by MOCON, Inc.). At the time of the measurement, the inorganic compound thin film surface was set to be the oxygen gas side.

2) Water vapor transmission rate

According to JIS K7129-B, measurement was carried out under the conditions of 40°C and 90% RH using a water vapor transmission rate measurement apparatus (PERMATRAN-W 3/31, manufactured by MOCON, Inc.) (measurement [1]). Thereafter, after each sample was subjected to a humidifying treatment at 40°C and 90% RH for 50 hours, measurement of the water vapor transmission rate was carried out again (measurement [2]). At that time, the rate of change of water vapor transmission rate (ΔWVTR) was also confirmed. The calculation method is as follows.

$$\Delta \text{WVTR} = (\text{measurement [2]} - \text{measurement [1]})/\text{measurement [1]} \times 100 \quad \dots \quad \text{Equation (4)}$$

At the time of the measurement, the inorganic compound thin film surface was set to be the higher humidity side.

3) Composition and thickness of inorganic compound thin film

The film composition was measured on the basis of a calibration curve previously produced using a fluorescent X-ray analysis apparatus (ZSX 100e, manufactured by Rigaku Corporation). The conditions of the excited X-ray emission tube were set to 50 kV and 70 mA.

[Example 1]

A 12 $\mu$m-thick polyethylene terephthalate (PET) film (E5100, manufactured by TOYOBO CO., LTD.) was used as a plastic film, and a layered film was obtained by forming an inorganic compound thin film made of aluminum oxide (vapor deposition material 1) and magnesium oxide (vapor deposition material 2) on the film by vapor deposition.
More specifically, granular aluminum oxide (purity 99%) in a size of about 3 to 6 mm was used as the vapor deposition material 1, and granular magnesium oxide (purity not less than 99.9%) in a size of about 2 to 6 mm was used as the vapor deposition material 2. The respective materials 1 and 2 were set separately in vapor deposition sources without being mixed. An electron gun (JOBG-1000UB, manufactured by JEOL Ltd.; maximum output power 100 kW) was used for heating.
Aluminum oxide and magnesium oxide were irradiated and heated with electron beam in a time-sharing manner using one electron gun, and thus aluminum oxide and magnesium oxide were evaporated to carry out vapor deposition of the inorganic compound thin film. The thickness and the composition of the inorganic compound thin film made of aluminum oxide and magnesium oxide were adjusted by adjusting the output power of the electron beam and the irradiation time in the scanning for the respective materials in a time-sharing manner. More specifically, the emission current of electron gun was set to 0.8A as the power of electron beam and electron beam irradiation time was divided according to rate that is aluminum oxide 67 for magnesium oxide 53. The pressure at the time of vapor deposition was not more than $2.5 \times 10^{-1}$ Pa.
In addition, the vapor deposition was carried out using a vacuum chamber equipped with an unwinding roll part, a coating roll part, and a winding up roll part. The plastic film having a width of 550 nm was set on the unwinding roll, and the vapor deposition was carried out continuously at a film feeding speed of 50 m/min. The temperature of the coating roll for cooling the film at the time of vapor deposition was adjusted to -10°C.

[Example 2]

A layered film was obtained in the same manner as in Example 1, except that the feeding speed of the film was set to 95 m/min, the emission current of electron gun was set to 1.2A, and electron beam irradiation time was divided according to rate that is aluminum oxide 19 for magnesium oxide 5 in Example 1.

[Example 3]

A layered film was obtained in the same manner as in Example 1, except that the feeding speed of the film was set to 30 m/min, the emission current of electron gun was set to 1.2A, and electron beam irradiation time was divided according to rate that is aluminum oxide 13 for magnesium oxide 2 in Example 1.

[Example 4]

A layered film was obtained in the same manner as in Example 1, except that the feeding speed of the film was set to 60 m/min, the emission current of electron gun was set to 1.2A, and electron beam irradiation time was divided according to rate that is aluminum oxide 107 for magnesium oxide 13 in Example 1.

[Example 5]

A layered film was obtained in the same manner as in Example 1, except that the feeding speed of the film was set to 60 m/min, the emission current of electron gun was set to 1.3A, and electron beam irradiation time was divided according to rate that is aluminum oxide 98 for magnesium oxide 22 in Example 1.

[Example 6]

A layered film was obtained in the same manner as in Example 1, except that the feeding speed of the film was set to 45 m/min, the emission current of electron gun was set to 1.4A, and electron beam irradiation time was divided according to rate that is aluminum oxide 5 for magnesium oxide 1 in Example 1.

[Example 7]

A layered film was obtained in the same manner as in Example 1, except that the feeding speed of the film was set to 60 m/min, the emission current of electron gun was set to 1.4A, and electron beam irradiation time was divided according to rate that is aluminum oxide 5 for magnesium oxide 1 in Example 1.

[Example 8]

A layered film was obtained in the same manner as in Example 1, except that a 25 $\mu$m-thick PET film (E5100, manufactured by TOYOBO CO., LTD.) was used as the plastic film, the feeding speed of the film was set to 65 m/min, the emission current of electron gun was set to 1.4A, and electron beam irradiation time was divided according to rate that is aluminum oxide 5 for magnesium oxide 1 in Example 1.

[Example 9]

A layered film was obtained in the same manner as in Example 1, except that a 50 $\mu$m-thick PET film (A4100, manufactured by TOYOBO CO., LTD.) was used as the plastic film, the feeding speed of the film was set to 50 m/min, the emission current of electron gun was set to 1.2A, and electron beam irradiation time was divided according to rate that is aluminum oxide 19 for magnesium oxide 5 in Example 1.

[Comparative Example 1]

A layered film was obtained in the same manner as in Example 1, except that the granular aluminum oxide (purity 99%) in a size of about 3 to 6 mm and the granular magnesium oxide (purity not less than 99.9%) in a size of about 2 to 6 mm were mixed at a substance amount ratio of 2.5 : 1.0, the feeding speed of the film was set to 110 m/min, and the emission current of electron gun was set to 0.7A in Example 1.

[Comparative Example 2]

A layered film was obtained in the same manner as in Example 1, except that the feeding speed of the film was set to 20 m/min, the emission current of electron gun was set to 1.4 A, and electron beam irradiation time was divided according to rate that is aluminum oxide 5 for magnesium oxide 1 in Example 1.

[Comparative Example 3]

A layered film was obtained in the same manner as in Example 1, except that the feeding speed of the film was set to 20 m/min, the emission current of electron gun was set to 1.4A, and electron beam irradiation time was divided according to rate that is aluminum oxide 5 for magnesium oxide 1 in Example 1.

Table 1 shows the thickness of the inorganic compound thin film, the content of the vapor deposition material 2 in the inorganic compound thin film, the oxygen transmission rate, the water vapor transmission rate, and the rate of change of water vapor transmission rate (ΔWVTR) after the layered film is treated at 40°C and 90% RH for 50 hours for each of the layered films obtained in the above-mentioned examples and comparative examples.

Table.1

| | vapor deposition material 1 | vapor deposition material 2 | content of vapor deposition material 2 [mass%] | thickness of the inorganic compound thin film [nm] | thickness of the plastic film [μm] | oxygen transmission rate [ml/m²· day· MPa] | water vapor transmission rate [g/m²· day] | water vapor transmission rate after the laminated film is humidity treated at 40°C and 90% RH for 50 hours [g/m²· day] | Δ WVTR [%] |
|---|---|---|---|---|---|---|---|---|---|
| Example 1 | $Al_2O_3$ | MgO | 85 | 29 | 12 | 11 | 0.84 | 0.59 | -30 |
| Example 2 | $Al_2O_3$ | MgO | 45 | 12 | 12 | 11 | 0.46 | 0.58 | 27 |
| Example 3 | $Al_2O_3$ | MgO | 18 | 32 | 12 | 10 | 0.68 | 0.66 | -3 |
| Example 4 | $Al_2O_3$ | MgO | 13 | 21 | 12 | 16 | 0.62 | 0.71 | 15 |
| Example 5 | $Al_2O_3$ | MgO | 36 | 24 | 12 | 10 | 0.26 | 0.30 | 15 |
| Example 6 | $Al_2O_3$ | MgO | 24 | 42 | 12 | 14 | 0.53 | 0.56 | 6 |
| Example 7 | $Al_2O_3$ | MgO | 29 | 26 | 12 | 11 | 0.90 | 0.99 | 10 |
| Example 8 | $Al_2O_3$ | MgO | 25 | 22 | 25 | 9 | 0.60 | 0.65 | 8 |
| Example 9 | $Al_2O_3$ | MgO | 47 | 32 | 50 | 5 | 0.40 | 0.48 | 21 |
| Comparative Example 1 | $Al_2O_3$ | MgO | 94 | 25 | 12 | 21 | 2.90 | 6.67 | 130 |
| Comparative Example 2 | $Al_2O_3$ | MgO | 28 | 100 | 12 | 814 | 6.20 | - | - |
| Comparative Example 3 | $Al_2O_3$ | MgO | 28 | 100 | 25 | 655 | 5.00 | - | - |

INDUSTRIAL APPLICABILITY

According to the present invention, it is made possible to provide a gas barrier layered film having high gas barrier properties to oxygen and water vapor. The gas barrier film of the present invention is widely usable for packaging uses for various kinds of foodstuffs, pharmaceutical products, and industrial products and also for industrial uses for solar cells, electronic paper, organic EL devices, semiconductor devices, etc., in which high gas barrier properties and durability are required, and is expected to greatly contribute to industrial fields.

**Claims**

1. A gas barrier film comprising an inorganic compound thin film formed on at least one surface of a plastic film, wherein the inorganic compound thin film contains aluminum oxide and magnesium oxide as main components, the ratio of magnesium oxide is not less than 5 mass% and not more than 90 mass% relative to 100 mass% in total of aluminum oxide and magnesium oxide contained in the inorganic compound thin film, and the thickness of the inorganic compound thin film is 5 to 80 nm.

2. The gas barrier film comprising an inorganic compound thin film formed on at least one surface of a plastic film according to claim 1, wherein the gas barrier film has a rate of change of water vapor transmission rate ($\Delta$WVTR) of not more than 50% after being treated at 40°C and 90% RH for 50 hours.

3. The gas barrier film according to claim 1 or 2, wherein the ratio of magnesium oxide is not less than 5 mass% and not more than 25 mass% relative to 100 mass% in total of aluminum oxide and magnesium oxide contained in the inorganic compound thin film, and the gas barrier film has a rate of change of water vapor transmission rate ($\Delta$WVTR) of not more than 50% after being treated at 40°C and 90% RH for 50 hours.

4. The gas barrier film according to claim 1 or 2, wherein the ratio of magnesium oxide is not less than 70 mass% and not more than 90 mass% relative to 100 mass% in total of aluminum oxide and magnesium oxide contained in the inorganic compound thin film, and the gas barrier film has a rate of change of water vapor transmission rate ($\Delta$WVTR) of not more than 50% after being treated at 40°C and 90% RH for 50 hours.

5. The gas barrier film according to any one of claims 1 to 4, wherein the thickness of the plastic film is not more than 50 $\mu$m.

6. The gas barrier film according to any one of claims 1 to 5, wherein the inorganic compound thin film is obtained by separately heating aluminum oxide and magnesium oxide.

## INTERNATIONAL SEARCH REPORT

| | International application No. |
|---|---|
| | PCT/JP2014/053409 |

A.    CLASSIFICATION OF SUBJECT MATTER
*B32B9/00*(2006.01)i, *C23C14/08*(2006.01)i

According to International Patent Classification (IPC) or to both national classification and IPC

B.    FIELDS SEARCHED

Minimum documentation searched (classification system followed by classification symbols)
B32B1/00-43/00, C23C14/08

Documentation searched other than minimum documentation to the extent that such documents are included in the fields searched
| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C.    DOCUMENTS CONSIDERED TO BE RELEVANT

| Category* | Citation of document, with indication, where appropriate, of the relevant passages | Relevant to claim No. |
|---|---|---|
| X<br>A | JP 06-23900 A  (Toyobo Co., Ltd.),<br>01 February 1994 (01.02.1994),<br>claim 1; paragraphs [0010], [0012], [0016]<br>(Family: none) | 1,5<br>2-4,6 |
| X<br>A | JP 06-23899 A  (Toyobo Co., Ltd.),<br>01 February 1994 (01.02.1994),<br>claim 1; paragraphs [0010], [0012], [0016]<br>(Family: none) | 1,5<br>2-4,6 |
| X<br>A | JP 10-329286 A  (Toppan Printing Co., Ltd.),<br>15 December 1998 (15.12.1998),<br>claims 1, 14; paragraphs [0058], [0059],<br>[0078], [0083]<br>(Family: none) | 1-5<br>6 |

| ☒ | Further documents are listed in the continuation of Box C. | ☐ | See patent family annex. |
|---|---|---|---|

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered    to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 April, 2014 (30.04.14) | 13 May, 2014 (13.05.14) |

| Name and mailing address of the ISA/<br>Japanese Patent Office | Authorized officer |
|---|---|
| Facsimile No. | Telephone No. |

Form PCT/ISA/210 (second sheet) (July 2009)

**INTERNATIONAL SEARCH REPORT**

International application No.

PCT/JP2014/053409

C (Continuation).   DOCUMENTS CONSIDERED TO BE RELEVANT

| Category* | Citation of document, with indication, where appropriate, of the relevant passages | Relevant to claim No. |
|---|---|---|
| X<br>Y<br>A | JP 2012-158820 A  (Mitsubishi Materials Corp.),<br>23 August 2012 (23.08.2012),<br>claim 1; paragraphs [0049], [0050], [0071],<br>[0109]<br>& CN 102628158 A | 1,5<br>6<br>2-4 |
| Y<br>A | JP 2007-160187 A  (Noguchi Shinku Kabushiki<br>Kaisha),<br>28 June 2007 (28.06.2007),<br>claims; paragraph [0041]<br>(Family: none) | 6<br>1-5 |
| Y<br>A | JP 07-102363 A  (Toyobo Co., Ltd.),<br>18 April 1995 (18.04.1995),<br>claims; paragraph [0010]<br>(Family: none) | 6<br>1-5 |
| Y<br>A | JP 03-140457 A  (Toyobo Co., Ltd.),<br>14 June 1991 (14.06.1991),<br>page 1, lower left column, lines 5 to 10;<br>page 2, lower left column, lines 4 to 8<br>(Family: none) | 6<br>1-5 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004082400 A
- JP 2002361778 A
- JP SHO61193841 A
- JP HEI07126835 A
- JP 2012158820 A